Europäisches Patentamt

(19) European Patent Office

Office européen des brevets

(11) Publication number: **0 144 654**
**A2**

(12) # EUROPEAN PATENT APPLICATION

(21) Application number: **84112589.1**

(22) Date of filing: **18.10.84**

(51) Int. Cl.⁴: **H 01 L 21/76**
**H 01 L 29/78**

(30) Priority: **03.11.83 US 548530**

(43) Date of publication of application:
**19.06.85 Bulletin 85/25**

(84) Designated Contracting States:
**DE FR NL**

(71) Applicant: GENERAL ELECTRIC COMPANY
1 River Road
Schenectady New York 12305(US)

(72) Inventor: Baliga, Bantval Jayant
3 Clove Court
Clifton Park New York 12065(US)

(72) Inventor: Chow, Tat-Sing Paul
708 Hampshire Seat
Schenectady New York 12309(US)

(74) Representative: Schüler, Horst, Dr. European Patent
Attorney et al,
Kaiserstrasse 41
D-6000 Frankfurt/Main 1(DE)

(54) Semiconductor device structure including a dielectrically-isolated insulated-gate transistor.

(57) An insulated-gate transistor is dielectrically isolated from other semiconductor devices in a monolithic semiconductor device structure. The insulated-gate transistor, in one form, includes, in successively adjoining relationship, a source region, a base region, a voltage-supporting region and a minority carrier injection region. The interfaces between selected, adjacent pairs of these device regions are oriented in their entireties orthogonal to a major surface of the semiconductor device structure that is planar. As a consequence, the insulated-gate transistor achieves a high current capacity as well as high voltage operation without the need for electric field rings. The insulated-gate transistor, in another form, constitutes a bidirectional device with the interfaces, between adjacent device regions being oriented as in the foregoing insulated gate transistor so as to also achieve the same advantages.

FIG. 1

## SEMICONDUCTOR DEVICE STRUCTURE INCLUDING
## A DIELECTRICALLY-ISOLATED INSULATED-GATE TRANSISTOR

### Background of the Invention

The present invention relates to a semiconductor device structure including an insulated-gate transistor (IGT) as well as further semiconductor devices, with the IGT and the further semiconductor devices being electrically separated from each other and also from a substrate of the semiconductor device structure.

IGTs are transistors that achieve low on-resistance due to bipolar action (i.e., current conduction due to both electrons and holes) while requiring gating circuitry of only low power to control their insulated gates. IGTs of the so-called vertical type are particularly adapted to function as power conditioning devices for switching large currents on and off. "Vertical type" signifies a device having two main current electrodes respectively positioned on opposite surfaces of a wafer so that device current flows "vertically" through the wafer. Vertical IGTs are described in, for example, DE-A-31 47 075, ——————————————— ——————————————— the entirety of which is hereby incorporated by reference.

It is often desirable to construct power conditioning devices in a monolithic semiconductor device

RD-14645    0144654

structure along with signal level semiconductor devices that are used for controlling the operation of the power conditioning devices through biasing of the control or gate electrodes of such power devices. This, however, requires dielectric isolation between the power conditioning devices and the signal level devices in order to avoid destructive short circuits between the two types of devices. Such dielectric isolation is achieved in the prior art by incorporating in a monolithic semiconductor device structure a substrate, a plurality of insulating tubs, and a plurality of semiconductor devices, with at least one semiconductor device disposed in each insulating tub. The insulating tubs dielectrically separate the respective device therein from the device in each other tub as well as from the substrate. The foregoing, prior art semiconductor device structures are provided in two basic variations as will be discussed below in connection with the preferred embodiments of the invention.

In the foregoing prior art semiconductor device structure, it is typical to fabricate included power conditioning devices in a so-called "lateral" configuration; that is, with all device electrodes on one surface and with main device current flow occurring laterally within the device. Examples of lateral IGTs per se are described and claimed in the copending and commonly- assigned European patent application 83112186.8 ——————————————————————————— the entirety of which is hereby incorporated by reference. One limitation of lateral IGTs such as described in the foregoing patent application is that their current capacity is considerably lower than for a vertical IGT. Accordingly, it would be desirable to provide a lateral IGT of high current capacity. Further, it would be desirable that such high current capacity IGT be provided in a semiconductor device structure incorporating dielectric isolation amongst a plurality of semiconductor devices.

### Objects of the Invention

An object of the present invention is to provide a semiconductor device structure including an IGT of high current capacity as well as further semiconductor devices that are dielectrically isolated from each other.

Another object of the invention is to provide a semiconductor device structure including a dielectrically-isolated IGT that can be operated at high voltage without the need for electric field rings.

A further object of the invention is to provide a semiconductor device structure including a dielectrically-isolated IGT wherein the device structure can be fabricated with conventional semiconductor device processing techniques.

## Summary of the Invention

The foregoing and other objects of the invention are achieved in a particularly preferred embodiment of a semiconductor device structure that includes a substrate and a plurality of insulating tubs disposed on the substrate. In each insulating tub there is disposed at least one semiconductor device, with one insulating tub having an IGT disposed therein. The insulating tubs dielectrically space the respective semiconductor device therein from the device in each other tub and also from the substrate. The foregoing IGT comprises, in successively adjoining relationship, a source region, a base region, a voltage-supporting region, and a minority carrier injection region, these regions extending into the semiconductor device structure from a major, substantially planar surface. The interfaces between adjacent pairs of the IGT regions are oriented in their entireties transverse to the aforesaid major surface. With the foregoing interfaces so oriented, the IGT attains a high current capacity as well as high voltage operation without requiring electric field rings and can be fabricated using conventional technology.

## Brief Description of the Drawings

While the specification concludes with claims defining the features of the invention that are regarded as novel, it is believed that the invention, together with further objects thereof will be better understood from considering the following description in conjunction with the drawing figures, in which:

Fig. 1 is a schematic tridimensional view, partially in cross section, of a semiconductor device structure in accordance with the invention;

Fig. 2 is a schematic, tridimensional view partially in cross section, of a semiconductor device device structure in accordance with the invention;

Fig. 3 is a schematic, tridimensional view, partially in cross section of another embodiment of the present invention; and

Fig. 4 is a schematic, tridimensional view, partially in cross section, of an additional embodiment of the invention.

### Description of the Preferred Embodiments

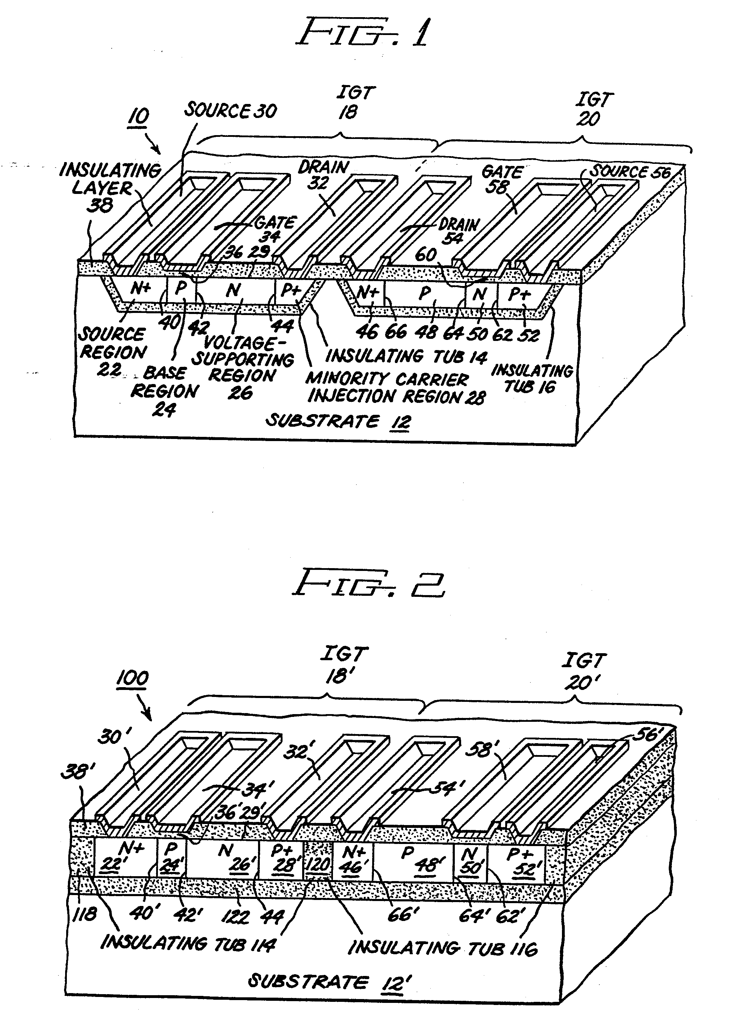

There is shown in Fig. 1 a portion of a semiconductor device structure 10 in accordance with the present invention. This device structure 10 includes a substrate 12 preferably formed from polysilicon. Included in device structure 10 are insulating tubs 14 and 16, which are disposed on substrate 12, and semiconductor devices 18 and 20, which are disposed in insulating tubs 14 and 16, respectively. Insulating tub 14 dielectrically spaces semiconductor device 18 from substrate 12 and also from semiconductor device 20, while insulating tub 16 dielectrically spaces semiconductor device 20 from substrate 12 and also from semiconductor device 18. Insulating tubs 14 and 16 preferably comprise silicon dioxide, although they may comprise other insulating or semi-insulating material such as Semi Insulating Polycrystalline Oxygen Doped Silicon (SIPOS).

Semiconductor device 18 comprises an IGT including in successively adjoining, lateral relationship, an N+ source region 22, a P base region 24, an N voltage-supporting region 26, and a P+ minority carrier injection region 28, the letters "P" and "N" referring to P and N conductivity type semiconductor material, respectively, while the designation "+" refers to a high dopant concentration. IGT 18 further includes on its upper portion a source electrode 30 adjoining source region 22, a drain electrode 32 adjoining P+ minority carrier injection region 28, and a control or gate electrode 34 dielectrically spaced from P base region 24 by a portion 36 of insulating layer 38 that is disposed generally on the upper portion of semiconductor device structure 10. IGT regions 22, 24, 26 and 28 preferably comprises silicon semiconductor material although they may alternatively comprise gallium arsenide semiconductor material, by way of example. IGT regions 22, 24, 26 and 28 extend into semiconductor device structure 10 from a wafer surface 29, which is planar. These regions are preferably configured, as viewed from above in Fig. 1, as elongated rectangles with, for example, drain electrode 32 being of the same configuration as P+ minority carrier injection region 28 and extending towards the rear of semiconductor device structure 10 as does P+ minority carrier injection region 28. The rear boundary of regions 22, 24, 26 and 28 in IGT 18 (not shown) is coterminous with the rear boundary of insulating tube 14 (not shown).

In IGT 20, regions 22 and 24 adjoin each other at an interface 40 with regions 24 and 26 adjoining each other at an interface 42 and regions 26 and 28 adjoining each other at an interface 44. In accordance with the present invention, interfaces 42 and 44 are oriented in their entireties transverse to and preferably orthogonal to, device structure major surface 29. With the latter interface being so oriented, the minority carriers injected by minority carrier injection region 28 into voltage-supporting region 26 are directed immediately into the horizontal current path (not illustrated) through voltage-supporting region 26, such region (as well as the further regions in IGT 18), in actuality, being much thinner than as illustrated. This minimizes the length of travel of such injected minority carriers and results in IGT 18 advantageously attaining a high level of current-carrying capacity that is comparable to that attainable in a conventional IGT of vertical construction.

With interfaces 42 and 44 oriented as described, the electric field curvature effects at these interfaces is minimized whereby IGT 18 can operate at high voltage without the need for so-called electric field rings that are conventionally used to compensate for accentuated electric field curvature.

IGT 18 typically incorporates base 24-to-source 30 electrical shorts (not illustrated) that are useful in preventing the inherent thyristor (i.e., N-P-N-P structure) in IGT 18 from latching on in thyristor fashion. This may be accomplished, for example, by forming source region 22 as a multiplicity of short rectangular portions aligned with source 30, as viewed from above in Fig. 1, with these N-conductivity type portions of source region 22 being separated from each other by respective P-conductivity type regions. These P-conductivity type regions, which would also appear as short rectangular portions as viewed from above in Fig. 1, ohmically contact source 30 and additionally contact P base region 24, thereby completing base 24-to-source 30 shorts in IGT 18.

Semiconductor device 20 comprises an IGT that is complementary to IGT 18; that is, it utilizes N-conductivity type semiconductor material in lieu of P-conductivity type semiconductor material and vice versa. Accordingly, IGT 20 includes N+ minority current injection region 46, P voltage-supporting region 48, N base region 50, and P+ source region 52. IGT 20 further includes a drain electrode 54 adjoining N+ minority current injection region 46, a source electrode 56 adjoining P+ source region and a gate electrode 58 dielectrically spaced from N base region 50 by portion 60 of insulating layer 38.

In IGT 20, regions 50 and 52 adjoin each other at an interface 62; regions 48 and 50 adjoin each other at an interface 64; and regions 46 and 48 adjoin each other at an interface 66. In accordance with the present invention, interfaces 64 and 66 are oriented in their entireties transverse to, and preferably orthogonal to, major surface 29. IGT 20 accordingly attains the advantages of high current capacity and high voltage operation without electric field rings.

IGT 20 typically includes base 50-to-source 56 shorts (not shown) that are suitably complementary in structure to the base 24-to-source 30 shorts (not shown) of semiconductor device structure 10 as described above.

The fabrication of semiconductor device 10 with regard to the provision of substrate 12 and insulating tubs 14 and 16 may employ conventional techniques. One suitable technique for accomplishing this is described in, for example, T. Suzuki, et al. "Deformation in Dielectric-Isolated Substrates and Its Control by a Multi-layer Polysilicon Support Structure", J. Electrochem. Soc.: Solid-State Science and Technology, Vol. 127 (July 1980) pp. 1537-1542, the entirety of which is hereby incorporated by reference. The provision of undoped semiconductor material in insulating tubs 14 and 16 (not shown) used in forming the various regions shown, such as region 22, as well as the provision of insulating layer 38 atop semiconductor device structure 10 and the provision of the various electrodes atop insulating layer 38, such as source electrode 30, can be accomplished using conventional semiconductor device processing techniques. The doping of the individual regions of IGT 18 and IGT 20, such as source region 22 of IGT 18, is preferably accomplished using ion implantation. This results in interfaces 42 and 44 (IGT 18) and interfaces 64 and 66 (IGT 20) being oriented in their entireties transverse to major surface 29 in accordance with the invention. The height and width (left-to-right dimension) of voltage-supporting region 26 as well as the dopant concentration thereof are selected to provide a desired breakdown voltage for IGT 18 in a manner that will be readily ascertainable by those skilled in the art. The width (left-to-right dimension) and dopant concentration of P base region 24 are selected to provide a desired gating characteristic for IGT 18 in a manner that will be readily ascertainable to those skilled in the art. The corresponding parameters of P voltage-supporting region 48 and N base region 50 of IGT 20 are similarly selected to provide desired breakdown voltage and gating characteristics of IGT 20, respectively.

IGTs 18 and 20 may be interconnected or connected to other semiconductor devices in device structure 100 by conventional metallization (not shown) atop device structure 100.

Turning now to Fig. 2 there is shown a semiconductor device structure 100 in accordance with a further embodiment of the invention. Device structure 100 bears many similarities to the above-described device structure 10 (Fig. 1), with like reference numerals as between device structure 100 and device structure 10 referring to like parts. In general, device structure 100 includes IGTs 18' and 20' that are dielectrically spaced from substrate 12' by insulating tubs 114 and 116, respectively. Device structure 100 differs from device structure 10 particularly in regard to the structure of their respective insulating tubs and substrate. Specifically, insulating tub 114, for example, comprises side portions 118 and 120 and bottom portion 122 with substrate 12' preferably comprising silicon, while insulating tub 14, for example, of device structure 10 comprises a unitary insulating layer with substrate 12 preferably comprising polysilicon. In insulating tub 114 (Fig. 2), portions 118, 120, and 122 preferably comprises silicon dioxide, although they may alternatively comprise spinel, by way of example. Substrate 12' suitably comprises sapphire or spinel as alternatives to silicon. With insulating tub portion 122 and substrate 12' comprising the same material, such as spinel, these regions may be provided by a single bulk wafer.

Interfaces 42' and 44' (IGT 18') and interfaces 64' and 66' (IGT 20') are oriented in their entireties transverse to, and preferably orthogonal to, major surface 29', whereby these IGTs achieve high current operation as well as high voltage operation without the need for electric field rings.

The fabrication of semiconductor device structure 100 as regards the provision of substrate 12' and insulating tubs 114 and 116 can be accomplished using conventional techniques. One suitable technique is discussed in, for example, an article by A.C. Ipri, "The Properties of Silicon-on-Sapphire Substrates, Devices and Integrated Circuits," contained in D. Kahng, Applied Solid State Science, Supplement 2, Silicon Integrated Circuits, Part A, New York: Academic Press (1981), pages 253=295, the entirety of which is hereby incorporated by reference.

The provision of insulating layer 38' atop device structure 100 as well as the provision of the electrodes atop device structure 100, such as source electrode 30', can be accomplished using conventional semiconductor processing techniques. The provision of semiconductor material in insulating tubs 114 and 116 from which the various semiconductor regions of IGTs 18'
and 20' are to be formed, such as source region 22' of
IGT 18', can be provided using conventional techniques,
one of which is discussed in the foregoing article by A.C. Ipri, for
example. The other fabrication details for semiconductor
device structure 100 are essentially identical to the
fabrication details for device strucure 10 as described
above.

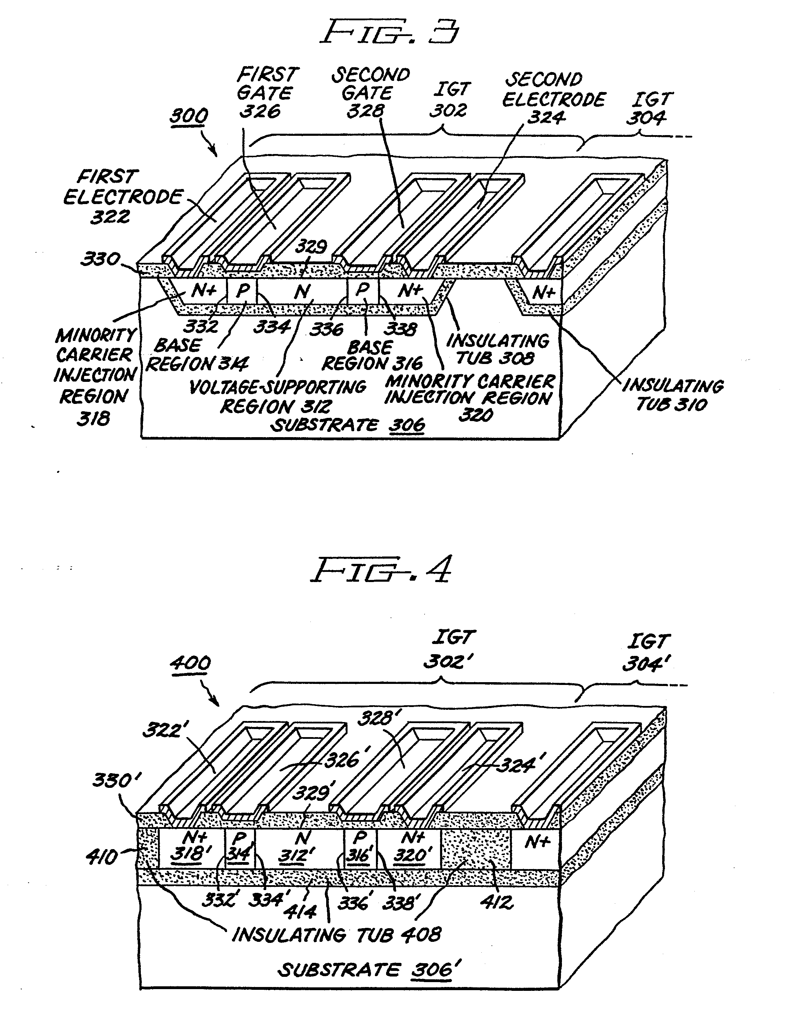

Turning to Fig. 3, there is shown a semiconductor device structure 300 that includes a bidirectional
IGT 302 and a further semiconductor device 304. Semiconductor device structure 300 includes a substrate 306,
preferably of polysilicon, and insulating tubs 308 and
310, which dielectrically space IGT 302 and semiconductor
device 304 from each other and from substrate 306,
respectively.

IGT 302 includes a voltage-supporting region
312, a pair of base regions 314 and 316, which are
symmetrical to each other about region 312, and a pair
of source regions 318 and 320, which are symmetrical to
each other about region 312. IGT 302 further includes
first and second electrodes 322 and 324, respectively,
which adjoin minority carrier injection regions 318 and
320, respectively, and which are symmetrical to each
other about voltage-supporting region 312. IGT 302
additionally includes first and second gates 326 and 328, respectively, dielectrically spaced by insulating layer 330 from base regions 314 and 316, respectively, the gates being symmetrical to each other about voltage-supporting region 312.

In accordance with the invention, the interfaces in IGT 302 between adjacent semiconductor regions, such as interface 332 between regions 314 and 318 are oriented in their entireties transverse to, and preferably orthogonal to, major surface 329, which is substantially planar. Accordingly, IGT 302 achieves high current operation (due to interfaces 332 and 338) as well as high voltage operation without the need for electric field rings (due to interfaces 334 and 336).

Although not illustrated, IGT 302 typically includes base 314-to-first electrode 322 shorts and base 316-to-second electrode 324 shorts. These shorts are suitably formed in the same manner as base 24-to-source 30 shorts (not shown) of semiconductor device structure 10 as described above.

Semiconductor device structure 300 is shown as including a portion of semiconductor device 304, which may comprise a bidirectional IGT, such as IGT 302, or which may comprise another type of power conditioning or signal level device or devices.

Bidirectional IGT 302 may be operated in two modes. First, it may be operated with first and

0144654

second electrodes 322 and 324, respectively, comprising source and drain electrodes, respectively, with first gate 326 being used to gate the device and second gate 328 being unused. Second, IGT 302 may be operated with first and second electrodes 322 and 324, respectively, comprising drain and source electrodes, respectively, with second gate 328 being used to gate the device and first gate 326 being unused.

In regard to the fabrication of semiconductor device structure 300, substrate 306 and insulating tubs 308 and 310 are suitably formed using conventional techniques, one of which is discussed in the above-referenced article to Suzuki et al. Insulating layer 330 and the electrodes atop device structure 300, such as first electrode 322, are suitably fabricated using conventional semiconductor device processing technology. The provision of undoped semiconductor material (not shown) in insulating tubs 308 and 310, which is then doped to form the various regions of IGT 302, such as $N^+$ minority carrier injection region 318, is suitably provided using conventional technology. The doping of the various semiconductor regions of IGT 302, such as $N^+$ region 318, is preferably carried out with ion implantation so as to result in each of the interfaces between adjacent semiconductor regions in IGT region 302, such as interface 332, being oriented in their entireties transverse to major surface 329, which is planar. The breakdown voltage of IGT 302 is determined by the combination of height, width (left-to-right dimension) and dopant concentration parameters of N voltage-supporting region 312, which parameters will be readily ascertainable to those skilled in the art for a desired breakdown voltage. The gating characteristics of IGT 302 are determined by the width (left-to-right dimension) and dopant concentration parameters of P base regions 314 and 316, as will be readily ascertainable by those skilled in the art for a desired gating characteristic.

Considering now Fig. 4, there is shown a semiconductor device structure 400 that bears many similarities to semiconductor device structure 300 of Fig. 3. Accordingly, like reference numerals as between Figs. 3 and 4 refer to like parts. A major structural distinction between device structure 400 and device structure 300 lies in the different configurations of their respective insulating tubs and device substrates. In particular, device structure 400 incorporates an insulating tub 408 comprised of left and right side portions 410 and 412, respectively, and a bottom portion 414, whereas, in device structure 300, insulating tub 308 is comprised of a unitary insulating layer.

In accordance with the invention, the interfaces in IGT 302' between adjacent semiconductor regions thereof, such as interface 332' between device regions 314' and 318, are oriented in their entireties transverse to, and preferably orthogonal to, major surface 329', which is planar. This results in IGT 302' achieving a high current capacity (due to interfaces 332' and 338') as well as high voltage operation without the need for electric field rings (due to interfaces 334' and 336').

The fabrication of semiconductor device structure 400 in regard to the provision of substrate 306' and insulating tub 408 is suitably accomplished by conventional techniques, one of which is described in the foregoing article by A.C. Ipri, for example. The fabrication of insulating layer 330' and the electrodes atop device structure 400, such as electrode 322', is suitably accomplished using conventional technology. The provision of undoped semiconductor material (not shown) for implementing the various semiconductor regions of IGT 302', such as region 318', is suitably accomplished with conventional techniques, one of which is described in the foregoing article by A.C. Ipri. The other fabrication details for semiconductor device structure 400 are essentially identical to the fabrication details for device structure 300 as described above.

The foregoing describes semiconductor device structures in which IGTs are dielectrically spaced from

RD-14 615

a substrate by insulating tubs. The IGTs advantageously achieve high current capacity as well as high voltage capacity without the need for electrical field rings and, further, can be fabricated using conventional semiconductor device processing technology.

While the invention has been described with respect to specific embodiments, many modifications and substitutions will occur to those skilled in the art. It is, therefore, to be understood that the appended claims are intended to cover all such modifications and substitutions as fall within the true spirit and scope of the invention.

CLAIMS

1. A semiconductor device structure comprising a substrate, a plurality of insulating tubs disposed on said substrate, and, disposed in each insulating tub, at least one respective semiconductor device, said insulating tubs dielectrically spacing the respective semiconductor device therein from the semiconductor devices in all other insulating tubs and also from the substrate, said semiconductor device structure further comprising:

an insulated-gate transistor constituting one of said respective semiconductor devices and including, in successively adjoining relationship, a source region, a base region, a voltage-supporting region, and a minority-carrier injection region, each of said regions extending into said semiconductor device structure from a major, planar surface;

said minority carrier injection region and said voltage-supporting region defining an interface therebetween, the entirety of which interface is oriented transverse to said major surface so as to enhance the current capacity of said insulated-gate transistor.

2. The semiconductor device structure of claim 1 wherein said voltage-supporting region and said base region define a second interface therebetween, said second interface being oriented in its entirety transverse to said major surface so as to permit high voltage operation of said insulated-gate transistor without the need for electric field rings therein.

3. The semiconductor device structure of claim 2 wherein said first-mentioned and said second interfaces are oriented in their entireties orthogonal to said major surface.

4. The semiconductor device structure of claim 1 wherein said insulating tub in which said insulated-gate transistor is disposed shares a common insulating portion with at least another of said plurality of insulating tubs.

5. The semiconductor device structure of claim 4 wherein, in said insulated-gate transistor, said source region, said base region, said voltage-supporting region and said minority-carrier injection region each comprise silicon semiconductor material.

6. The semiconductor device structure of claim 1 wherein said insulating tub in which said insulated-gate transistor is disposed is spaced from the remainder of said plurality of insulating tubs.

7. The semiconductor device structure of claim 6 wherein, in said insulated-gate-transistor, said source region, said base region, said voltage-supporting region and said minority-carrier injection region each comprise silicon semiconductor material.

8. A semiconductor device structure comprising a substrate, a plurality of insulating tubs disposed on said substrate, and, disposed in each insulating tub, at least one respective semiconductor device, said insulating tubs dielectrically spacing the respective semiconductor device therein from the semiconductor devices in all other insulating tubs and also from the substrate, said semiconductor device structure further comprising:

a bidirectional insulated-gate transistor constituting one of said respective semiconductor devices and including, in successively adjoining relationship, a first minority carrier injection region, a first base region, a voltage-supporting region, a second base region, and a second minority carrier injection region, each of said regions extending into said semiconductor device structure from a major, planar surface;

said first minority carrier injection region and said first base region defining a first interface therebetween and said second minority carrier injection region and said second base region defining a second interface therebetween, said first and second interfaces being oriented in their entireties transverse to said major surface so as to enhance the current capacity of said bidirectional insulated-gate transistor.

9. The semiconductor device structure of claim 7 wherein said voltage-supporting region and said first base region define a third interface therebetween and said voltage-supporting region and said second base region define a fourth interface therebetween, said third and fourth interfaces being oriented in their entireties transverse to said major surface so as to permit high voltage operation of said bidirectional insulated-gate transistor without the need for electric field rings therein.

10. The semiconductor device structure of claim 9 wherein said first, second, third and fourth interfaces are oriented in their entireties orthogonal to said major surface.

11. The semiconductor device structure of claim 8 wherein said insulating tub in which said bidirectional insulated-gate transistor is disposed shares a common insulating portion with at least another of said plurality of insulating tubs.

12. The semiconductor device structure of claim 11 wherein, in said bidirectional insulated-gate transistor, said first and second minority carrier injection regions, said first and second base regions and said voltage-supporting region each comprise silicon semiconductor material.

13. The semiconductor device structure of claim 8 wherein said insulating tub in which said bi-

0144654.

RD-14,615

directional insulated-gate transistor is disposed is spaced from the remainder of said plurality of insulating tubs.

14. The semiconductor device structure of claim 13 wherein, in said bidirectional insulated-gate transistor, said first and second minority carrier injection regions, said first and second base regions and said voltage-supporting region each comprise silicon semiconductor material.

———

## FIG. 1

## FIG. 2

0144654

## FIG. 3

FIRST ELECTRODE 322
FIRST GATE 326
SECOND GATE 328
IGT 302
SECOND ELECTRODE 324
IGT 304
300
329
330
N+ | P | N | P | N+ | N+
332 | 334 | 336 | 338
MINORITY CARRIER INJECTION REGION 318
BASE REGION 314
VOLTAGE-SUPPORTING REGION 312
BASE REGION 316
INSULATING TUB 308
MINORITY CARRIER INJECTION REGION 320
INSULATING TUB 310
SUBSTRATE 306

## FIG. 4

IGT 302'
IGT 304'
400
322'
328'
326'
324'
330'
329'
410
N+ 318' | P 314 | N 312' | P 316' | N+ 320' | N+
332' | 334' | 414 | 336' | 338' | 412
INSULATING TUB 408
SUBSTRATE 306'